# EUROPÄISCHE PATENTANMELDUNG

(11) **EP 1 424 728 A1**
(43) Veröffentlichungstag der Anmeldung: **02.06.2004**
(21) Anmeldenummer: 02406028.7
(22) Anmeldetag: 27.11.2002
(51) Int. Cl.: H01L 23/29, H01L 23/31

(54) **Leistungshalbleitermodul**

(71) Anmelder: ABB RESEARCH LTD., 8050 Zürich (CH)
(72) Erfinder: Knapp, Wolfgang, 5600 Lenzburg (CH); Keser, Helmut, 5443 Niederrohrdorf (CH)
(74) Vertreter: ABB Patent Attorneys

(57) **Zusammenfassung**

Es wird ein Leistungshalbleitermodul mit einem aus einem aushärtbaren Vergusskunststoff gebildeten Gehäuse (1) und mit einer Grundplatte (2) angegeben, wobei auf einem Teil der dem Gehäuse (1) zugewandten Fläche der Grundplatte (2) elektrische Leistungshalbleiterbauelemente (4) über eine isolierende Schicht (5) angebracht sind. Zumindest der Teil der dem Gehäuse (1) zugewandten Fläche der Grundplatte (2) mit den angebrachten elektrischen Leistungshalbleiterbauelementen (4) ist mit dem Gehäuse () vergossen, wobei der aushärtbare Vergusskunststoff ein thermoplastischer Schmelzklebstoff ist.

## Beschreibung

### Technisches Gebiet

Die Erfindung bezieht sich auf das Gebiet der Leistungshalbleitertechnik. Sie geht aus von einem Leistungshalbleitermodul gemäss dem Oberbegriff des Anspruchs 1.

### Stand der Technik

Leistungshalbleitermodule, insbesondere mit als Bipolartransistoren mit jeweils isoliert angeordneter Ansteuerelektrode ausgeführten elektrischen Leistungshalbleiterbauelementen, werden heute in einer Fülle von leistungselektronischen Schaltungen, insbesondere in Umrichterschaltungen, eingesetzt. Ein solches Leistungshalbleitermodul ist beispielsweise in der US 6,201,696 angegeben. Darin weist das Leistungshalbleitermodul ein Gehäuse auf, welches beispielweise einen Kunststoff umfasst. Als Kunststoff ist ein aushärtbarer Vergusskunststoff in Form eines thermoplastischen Harzes, beispielsweise Epoxydharz, also ein Duroplast gewählt. Desweiteren ist eine Grundplatte vorgesehen, wobei auf der dem Gehäuse zugewandten Fläche der Grundplatte die bereits vorstehend erwähnten elektrischen Leistungshalbleiterbauelemente angeordnet sind und die elektrischen Leistungshalbleiterbauelemente üblicherweise auf dieser Fläche der Grundplatte über eine isolierende Schicht angebracht sind.

Nach der US 6,201,696 sind die elektrischen Leistungshalbleiterbauelemente, die isolierende Schicht und Teile dem Gehäuse zugewandten Fläche der Grundplatte in das durch das Epoxydharz gebildete Gehäuse eingegossen, wobei zusätzlich mit zumindest einem der elektrischen Leistungshalbleiterbauelemente verbundene Leistungsanschlusselemente mit dem Gehäuse vergossen sind und Anschlussenden der Leistungsanschlusselemente aus dem Gehäuse geführt sind.

Problematisch bei einem vorstehend beschriebenen und in der US 6,201,696 offenbarten Leistungshalbleitermodul ist, dass das Epoxydharz zur Ausformung des Gehäuses unter hoher Temperatur in der Grössenordnung 230°C und unter hohem Druck in der Grössenordnung 30 bis 150 bar in eine entsprechende Form eingebracht werden muss. Die Herstellung des Leistungshalbleitermoduls ist dadurch aus prozesstechnischer Sicht aufwendig, kompliziert und damit teuer. Desweiteren ist das ausgehärtete Epoxydharz sehr spröde und demnach nahezu nicht elastisch deformierbar. Bei Erwärmung des Gehäuses durch die eingegossenen elektrischen Leistungshalbleiterbauelemente kann es deshalb zu unerwünschten Spannungen kommen, wodurch Risse im Gehäuse entstehen. Die isolierende Wirkung des Gehäuses bezüglich der elektrischen Leistungshalbleiterbauelemente untereinander ist damit nicht mehr gewährleistet, wodurch es zu einer Beschädigung oder Zerstörung des Leistungshalbleitermoduls, insbesondere infolge eines Kurzschlusses, kommen kann. Darüber hinaus ist durch die Sprödigkeit des Gehäuses eine erhöhte stoss- und schlagempfindlich des Leistungshalbleitermoduls gegeben, wodurch es bei Einsatz in einem rauhen Umfeld, d.h. beispielsweise bei hohen Beschleunigungskräften in Form von Rüttelbewegungen, zu den vorstehend bereits erwähnten Rissen mit den entsprechenden Folgen kommen kann. Ferner ist durch solche hohen Beschleunigungskräfte eine Rissbildung am Gehäuse im Austrittsbereich der Leistungsanschlusselemente möglich, so dass die Haltewirkung der Leistungsanschlusselemente durch das Gehäuse nicht mehr gegeben ist und es zu einem Abriss der Anschlusselemente kommen kann. Der Betrieb des Leistungshalbleitermoduls ist dann nicht mehr oder nicht mehr sinnvoll möglich.

### Darstellung der Erfindung

Aufgabe der Erfindung ist es deshalb, ein Leistungshalbleitermodul anzugeben, welches bezüglich seines Gehäuses ein hohes Mass an elastischer Deformierbarkeit aufweist und prozesstechnisch sehr einfach herzustellen ist. Diese Aufgabe wird durch die Merkmale des Anspruchs 1 gelöst. In den abhängigen Ansprüchen sind vorteilhafte Weiterbildungen der Erfindung angegeben.

Das erfindungsgemässe Leistungshalbleitermodul weist ein aus einem aushärtbaren Vergusskunststoff gebildetes Gehäuse und eine Grundplatte auf, wobei auf einem Teil der dem Gehäuse zugewandten Fläche der Grundplatte elektrische Leistungshalbleiterbauelemente über eine isolierende Schicht angebracht sind. Zumindest der Teil der dem Gehäuse zugewandten Fläche der Grundplatte mit den angebrachten elektrischen Leistungshalbleiterbauelementen ist mit dem Gehäuse vergossen. Erfindungsgemäss ist der aushärtbare Vergusskunststoff ein thermoplastischer Schmelzklebstoff. Vorteilhaft weist das Gehäuse des Leistungshalbleitermoduls im ausgehärteten Zustand durch Verwendung des Schmelzklebstoffes eine besonders hohe elastische Deformierbarkeit und einen hohen Wärmeausdehnungskoeffizienten auf, so dass bei Erwärmung des Gehäuses durch die eingegossenen elektrischen Leistungshalbleiterbauelemente nahezu keine unerwünschten Spannungen und eine daraus resultierende Rissbildung im Gehäuse auftreten kann. Darüber hinaus ist das erfindungsgemässe Leistungshalbleitermodul durch die elastische Deformierbarkeit des Gehäuses weitestgehend schlag- und stossunempfindlich, wodurch ein Einsatz des Leistungshalbleitermoduls in einem rauhen Umfeld, d.h. bei hohen Beschleunigungskräften in Form von Rüttelbewegungen, problemlos möglich ist. In einem solchen Umfeld ist die gewünschte Isolationswirkung des Gehäuses für die vergossenen elektrischen Leistungshalbleiterbauelemente untereinander und der elektrischen Leistungshalbleiterbauelemente gegenüber ausserhalb des Gehäuses aufgrund der vorstehend genannten geringen Wahrscheinlichkeit einer Rissbildung des Gehäuses nahezu stets gegeben.

Ferner weist das auf dem vorstehend erwähnten thermoplastischer Schmelzklebstoff basierende Gehäuse des Leistungshalbleitermoduls neben der beschriebenen elastischen Deformierbarkeit dennoch eine ausgezeichnete Festigkeit auf, so dass das Gehäuse beispielsweise problemlos zur Befestigung geklemmt werden kann, ohne dass es zu Rissen im Gehäuse kommt oder das Gehäuse berstet.

Desweiteren ist das erfindungsgemässe Leistungshalbleitermodul durch die Verwendung des thermoplastischen Schmelzklebstoffes für das Gehäuse vorteilhaft prozesstechnisch sehr einfach herstellbar, da sich der thermoplastische Schmelzklebstoff bereits bei einer niedrigen Temperatur und bei einem besonders geringen Druck vergiessen lässt.

Besonders bevorzugt enthält der Schmelzklebstoff ein Dimerfettsäurepolyamid. Dadurch ist eine besonders gute Isolationswirkung des Gehäuses für die vergossenen elektrischen Leistungshalbleiterbauelemente untereinander und der elektrischen Leistungshalbleiterbauelemente gegenüber ausserhalb des Gehäuses gegeben.

Diese und weitere Aufgaben, Vorteile und Merkmale der vorliegenden Erfindung werden aus der nachfolgenden detaillierten Beschreibung bevorzugter Ausführungsformen der Erfindung in Verbindung mit der Zeichnung offensichtlich.

### Kurze Beschreibung der Zeichnung

Es zeigen:
- Fig. 1: eine Schnittdarstellung einer ersten Ausführungsform eines erfindungsgemässen Leistungshalbleitermoduls und
- Fig. 2: eine Schnittdarstellung einer zweiten Ausführungsform des erfindungsgemässen Leistungshalbleitermoduls.

Die in der Zeichnung verwendeten Bezugszeichen und deren Bedeutung sind in der Bezugszeichenliste zusammengefasst aufgelistet. Grundsätzlich sind in den Figuren gleiche Teile mit gleichen Bezugszeichen versehen. Die beschriebenen Ausführungsformen stehen beispielhaft für den Erfindungsgegenstand und haben keine beschränkende Wirkung.

### Wege zur Ausführung der Erfindung

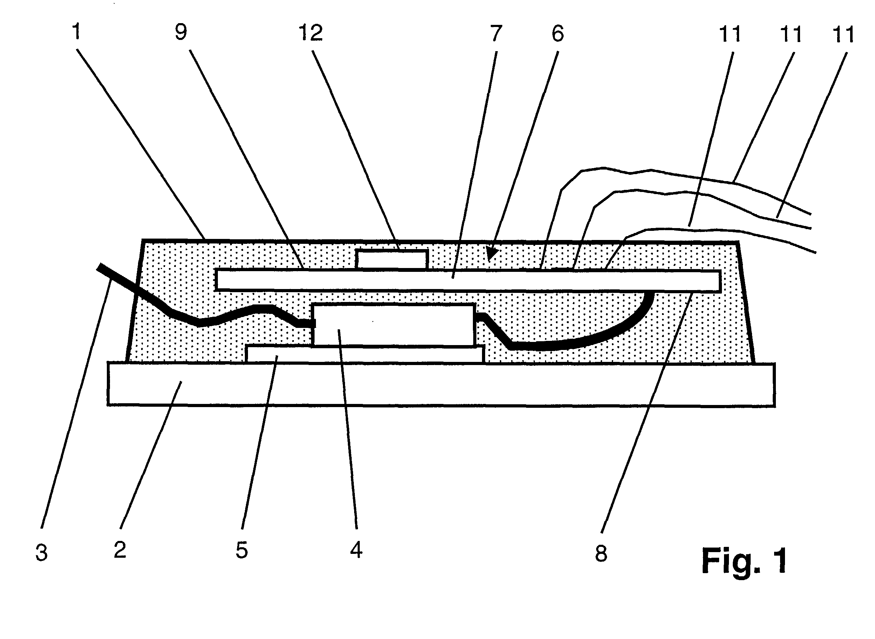

In Fig. 1 ist eine Schnittdarstellung einer ersten Ausführungsform eines erfindungsgemässen Leistungshalbleitermoduls dargestellt. Das erfindungsgemässe Leistungshalbleitermodul weist gemäss Fig. 1 ein aus einem aushärtbaren Vergusskunststoff gebildetes Gehäuse 1 und eine Grundplatte 2 auf, wobei auf einem Teil der dem Gehäuse 1 zugewandten Fläche der Grundplatte 2 elektrische Leistungshalbleiterbauelemente 4 über eine isolierende Schicht 5 angebracht sind. In Fig. 1 ist der Übersichtlichkeit halber nur ein solches elektrisches Leistungshalbleiterbauelement 4 gezeigt. Es ist aber auch denkbar, insbesondere für spezielle Anwendungen, dass die elektrischen Leistungshalbleiterbauelemente 4 anstelle über die isolierende Schicht 5 im wesentlichen direkt auf der dem Gehäuse 1 zugewandten Fläche der Grundplatte 2 angebracht sind, wodurch die isolierende Schicht 5 vorteilhaft eingespart werden kann. Gemäss Fig. 1 ist zumindest der Teil der dem Gehäuse 1 zugewandten Fläche der Grundplatte 2 mit den angebrachten elektrischen Leistungshalbleiterbauelementen 4 mit dem Gehäuse 1 vergossen. Erfindungsgemäss ist der aushärtbare Vergusskunststoff ein thermoplastischer Schmelzklebstoff. Durch die Verwendung des thermoplastischen Schmelzklebstoffes weist das Gehäuse 1 des Leistungshalbleitermoduls im ausgehärteten Zustand eine besonders hohe elastische Deformierbarkeit und einen hohen Wärmeausdehnungskoeffizienten auf. Bei Erwärmung des Gehäuses 1 durch die eingegossenen elektrischen Leistungshalbleiterbauelemente 4 bei deren Betrieb können somit vorteilhaft unerwünschten Spannungen und eine daraus resultierende Rissbildung im Gehäuse 1 weitestgehend verhindert werden. Ferner ist das erfindungsgemässe Leistungshalbleitermodul aufgrund der elastischen Deformierbarkeit des Gehäuses 1 weitestgehend schlag- und stossunempfindlich. Ein Einsatz des Leistungshalbleitermoduls in einem rauhen Umfeld, d.h. bei hohen Beschleunigungskräften in Form von Rüttelbewegungen, ist somit problemlos möglich. Die gewünschte Isolationswirkung des Gehäuses 1 für die vergossenen elektrischen Leistungshalbleiterbauelemente 4 untereinander und der elektrischen Leistungshalbleiterbauelemente gegenüber ausserhalb des Gehäuses 1 ist in einem solchen Umfeld aufgrund der vorstehend genannten geringen Wahrscheinlichkeit einer Rissbildung des Gehäuses 1 mit Vorteil nahezu stets gegeben.

Weiterhin weist das Gehäuse 1 des erfindungsgemässen Leistungshalbleitermoduls neben der beschriebenen elastischen Deformierbarkeit dennoch eine ausgezeichnete Festigkeit auf, so dass das Gehäuse 1 beispielsweise problemlos zur Befestigung an einem Körper geklemmt werden kann, ohne dass es zu Rissen im Gehäuse 1 kommt oder das Gehäuse 1 berstet.

Der thermoplastische Schmelzklebstoff enthält vorzugsweise ein Dimerfettsäurepolyamid. Dadurch ist eine besonders gute Isolationswirkung des Gehäuses 1 für die vergossenen elektrischen Leistungshalbleiterbauelemente 4 untereinander und der elektrischen Leistungshalbleiterbauelemente gegenüber ausserhalb des Gehäuses 1 gegeben.

Es hat sich als besonders vorteilhaft erwiesen, dass der Schmelzklebstoff eine Vergiesstemperatur im Bereich zwischen 150°C und 220°C aufweist, um den Schmelzklebstoff in diesem Temperaturbereich zu vergiessen. Weiterhin ist der Schmelzklebstoff vorteilhaft mit einem sehr niedrigen Vergiessdruck im Bereich von 0,1 MPa bis 0,5MPA vergiessbar. Durch die geringe Vergiesstemperatur und den niedrigen Vergiessdruck kann eine Blasenbildung des flüssigen thermoplastischen Schmelzklebstoffes während des Vergiessvorgangs weitestgehend vermieden werden. Die Möglichkeit von auftretenden Teilentladungen während des Berieb des Leistungshalbleitermoduls infolge Luft- oder Gaseinschlüssen im Gehäuse 1 kann somit auf ein Minimum reduziert werden. Die Formgebung des Gehäuses 1 wird vorzugsweise durch eine Aluminiumform erreicht. Beim Vergiessvorgang des Schmelzklebstoffes härtet der Schmelzklebstoff zuerst an den Berührungsflächen der Form aus und fliesst ansonsten bis zur vollständigen Aushärtung fortlaufend die Form. Durch die Fliesseigenschaften des Schmelzklebstoffes und die geringe Vergiesstemperatur sowie den niedrigen Vergiessdruckes ist eine hohe Dichtheit und Festigkeit des Gehäuses 1 erreicht, wobei die elektrischen Leistungshalbleiterbauelemente 4 und deren äusserst filigrane Aufbauten vorteilhaft vollständig und schonend eingegossen, abgedichtet, geschützt und in erwünschter Weise elektrisch gegeneinander isoliert werden.

Insgesamt ist das erfindungsgemässe Leistungshalbleitermodul, insbesondere das Gehäuse 1 aufgrund der geringen Vergiesstemperatur und des niedrigen Vergiessdruckes sowie durch die einfache Formgebung und die vorstehend genannte Fliesfähigkeit des Schmelzklebstoffes während des Vergiessvorgangs prozesstechnisch sehr einfach, insbesondere durch einfaches Giessen aber beispielsweise auch durch Spritzen, herstellbar.

Gängigerweise werden die elektrischen Leistungshalbleiterbauelemente 4 von einer Ansteuereinrichtung 6 angesteuert, welche beispielsweise eine Ansteuerelektrodenstufe aufweist, falls die elektrischen Leistungshalbleiterbauelemente 4 als Bipolartransistoren mit jeweils isoliert angeordneter Ansteuerelektrode ausgeführt sind. Die Ansteuereinrichtung ist somit, wie in Fig. 1 gezeigt, mit den elektrischen Leistungshalbleiterbauelementen 4 verbunden. Gemäss Fig. 1 weist das erfindungsgemässe Leistungshalbleitermodul eine solche mit mindestens einem der elektrischen Leistungshalbleiterbauelemente 4 verbundene Ansteuereinrichtung 6 auf, welche zumindest teilweise mit dem Gehäuse 1 vergossen ist. Gemäss Fig. 1 ist die Ansteuereinrichtung 6 beispielsweise vollständig in das Gehäuse 1 eingegossen. Die Ansteuereinrichtung 6 ist dadurch in das Leistungshalbleitermodul integriert und durch die elastische Deformierbarkeit des Gehäuses 1 vor mechanischen Einwirkungen geschützt. Weiterhin kann der Platzbedarf des Leistungshalbleitermoduls zusammen mit der Ansteuereinrichtung 6 durch die vorstehend genannte Integration der Ansteuereinrichtung 6 in das Gehäuse 1 erheblich verringert werden. Darüber hinaus ist die Verbindung der Ansteuereinrichtung 6 mit mindestens einem der elektrischen Leistungshalbleiterbauelemente 4 durch die Integration der Ansteuereinrichtung 6 in das Gehäuse 1 sehr kurz ausgeführt. Dadurch kann vorteilhaft Leitungsmaterial eingespart werden, wobei zusätzlich die Störanfälligkeit des Leistungshalbleitermoduls durch weitestgehende Vermeidung der Möglichkeit einer Einkopplung unerwünschter elektromagnetischer Wellen verringert wird.

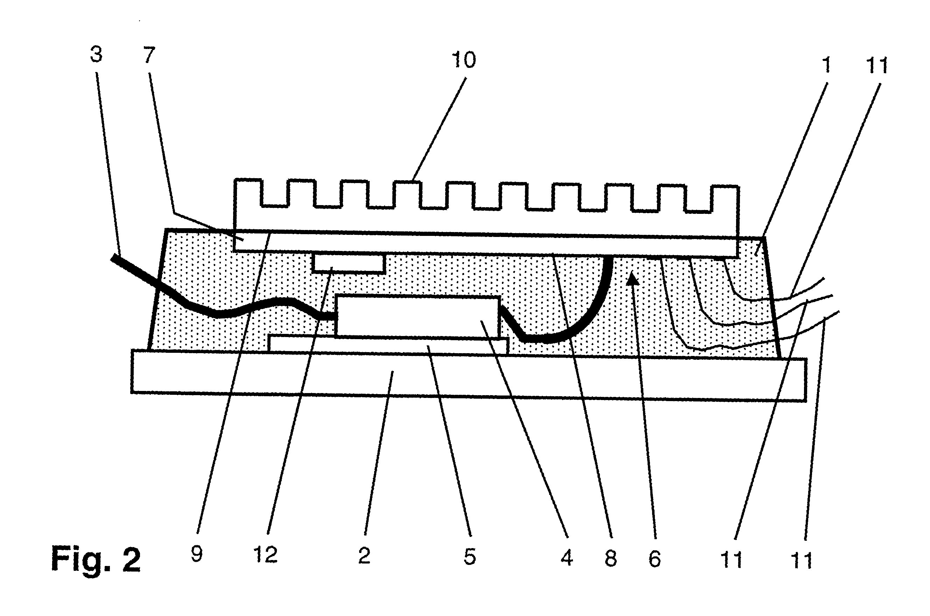

In Fig. 2 ist eine Schnittdarstellung einer zweiten Ausführungsform des erfindungsgemässen Leistungshalbleitermoduls gezeigt. Gemäss Fig. 1 und Fig. 2 weist die Ansteuereinrichtung 6 eine Leiterplatte 7 mit einer den elektrischen Leistungshalbleiterbauelementen 4 zugewandten ersten Leiterplattenfläche 8 und mit einer den elektrischen Leistungshalbleiterbauelementen 4 abgewandten zweiten Leiterplattenfläche 9 auf. Im Unterschied zu Fig. 1 ist die Ansteuereinrichtung 6 gemäss Fig. 2 nur teilweise mit dem Gehäuse vergossen, d.h., dass die erste Leiterplattenfläche 8 mit dem Gehäuse 1 vergossen ist und die zweite Leiterplattenfläche 9 ausserhalb des Gehäuses 1 liegt. Die Ausführungsform des erfindungsgemässen Leistungshalbleitermoduls gemäss Fig. 2 zeichnet sich vor allem dadurch aus, dass überschüssige Verlustwärmeenergie der elektrischen Leistungshalbleiterbauelemente 4 vom Inneren des Gehäuses 1 über die zweite Leiterplattenfläche 9 abgeführt werden kann. Zur weiteren Verbesserung der Abführung der angesprochenen Verlustwärmeenergie ist die zweite Leiterplattenfläche 9 gemäss Fig. 2 vorzugsweise mit einem Kühleelement 10 thermisch kontaktiert.

Gemäss Fig. 1 und Fig. 2 sind mit der Ansteuereinrichtung 6 verbundenen Ansteueranschlusselemente 11 mit dem Gehäuse 1 vergossen, wobei Anschlussenden der Ansteueranschlusselemente 11 aus dem Gehäuse 1 geführt sind. Die Ansteueranschlusselemente 11 dienen der Übertragung von Signalen beispielsweise einer übergeordneten Leitelektronikeinheit. Vorteilhaft sind die Ansteueranschlusselemente 11 als Kabel ausgebildet. Solche Kabel sind flexibel ausgebildet, wodurch eine Rissbildung am Gehäuse 1 im Austrittsbereich der Ansteueranschlusselemente 11 bei auftretenden hohen Beschleunigungskräften beispielsweise bei Einsatz in einem rauhen Umfeld weitestgehend verhindert werden kann. Als Kabel für die Ansteueranschlusselemente 11 haben sich sowohl Kabel mit elektrischen Leitern als auch Lichtwellenleiter bewährt.

Es sich weiterhin als vorteilhaft erwiesen, dass der Schmelzklebstoff im ausgehärteten Zustand im wesentlichen transparent oder opak ist, wodurch eine optische Kommunikation durch das Gehäuse 1 zu in Fig. 1 und Fig. 2 der Übersichtlichkeit nicht dargestellten optischen Empfangselementen der Ansteuereinrichtung 6 und/oder eine optische Kommunikation durch das Gehäuse 1 von in Fig. 1 und Fig. 2 der Übersichtlichkeit nicht dargestellten optischen Sendeelementen der Ansteuereinrichtung 6 ermöglicht ist. Die vorstehend genannten Elemente zur optische Kommunikation können anstelle der Ansteueranschlusselemente 11 oder zusätzlich zu den Ansteueranschlusselementen 11 vorgesehen sein.

Gemäss Fig. 1 und Fig. 2 ist ein mit einem der elektrischen Leistungshalbleiterbauelemente 4 verbundenes Leistungsanschlusselement 3 mit dem Gehäuse 1 vergossen. Das Leistungsanschlusselement 3 dient der Übertragung elektrischer Energie beziehungsweise Leistung über das elektrische Leistungshalbleiterbauelement 4. Allgemein ist mindestens ein mit mindestens einem der elektrischen Leistungshalbleiterbauelemente 4 verbundenes Leistungsanschlusselement 3 mit dem Gehäuse 1 vergossen, wobei ein Anschlussende des mindestens einen Leistungsanschlusselementes 3 aus dem Gehäuse 1 geführt ist. Weiterhin und ist das mindestens eine Leistungsanschlusselement 3 vorzugsweise als Kabel ausgebildet. Diese Kabel sind flexibel ausgebildet, wodurch eine Rissbildung am Gehäuse 1 im Austrittsbereich des Leistungsanschlusselementes 3 bei auftretenden hohen Beschleunigungskräften beispielsweise bei Einsatz in einem rauhen Umfeld weitestgehend verhindert werden kann. Als Kabel für das Leistungsanschlusselement 3 haben sich Kabel mit elektrischen Leitern besonders bewährt.

Im folgenden wird näher auf den für das Gehäuse 1 verwendeten thermoplastischen Schmelzklebstoff eingegangen. Der verwendete thermoplastische Schmelzklebstoff hat die vorteilhafte Eigenschaft, dass zwischen dem Schmelzklebstoff und einem Substrat eine mechanische Verkrallung beziehungsweise mechanische Verankerung, d.h. mit allen eingegossenen und teilweise eingegossenen Komponenten stattfindet. Vor allem die als Kabel ausgeführten Ansteueranschlusselemente 11 und das mindestens eine Leistungsanschlusselement 3 sind durch die Haftwirkung des ausgehärteten Schmelzklebstoffes mit der zugehörigen Kabelisolierung besonders fest mit dem Gehäuse 1 verbunden. Aber beispielsweise auch der Teil der dem Gehäuse 1 zugewandten Fläche der Grundplatte 2 mit den angebrachten elektrischen Leistungshalbleiterbauelementen 4 sowie die zumindest teilweise mit dem Gehäuse 1 vergossene Ansteuereinrichtung 6 sind durch die ausgezeichnete Haftwirkung des Schmelzklebstoffes mit dem Gehäuse 1 fest verbunden. Gerade bei den Ansteueranschlusselementen 11 und dem mindestens einen Leistungsanschlusselement 3 ist dadurch insbesondere am Gehäuse 1 an den Austrittsbereichen der vorstehend genannten Elemente 3, 11 eine Rissbildung nahezu unmöglich und die Haltewirkung dieser Elemente 3, 11 durch das Gehäuse 1 nahezu stets gegeben. Die Verfügbarkeit des erfindungsgemässen Leistungshalbleitermoduls insgesamt ist dadurch bedeutend gesteigert.

### Bezugszeichenliste

- 1: Gehäuse
- 2: Grundplatte
- 3: Leistungsanschlusselement
- 4: elektrisches Leistungshalbleiterbauelement
- 5: isolierende Schicht
- 6: Ansteuereinrichtung
- 7: Leiterplatte
- 8: erste Leiterplattenfläche
- 9: zweite Leiterplattenfläche
- 10: Kühlelement
- 11: Ansteueranschlusselement
- 12: elektronisches Bauteil

## Patentansprüche

1. Leistungshalbleitermodul mit einem aus einem aushärtbaren Vergusskunststoff gebildeten Gehäuse (1) und mit einer Grundplatte (2), wobei auf einem Teil der dem Gehäuse (1) zugewandten Fläche der Grundplatte (2) elektrische Leistungshalbleiterbauelemente (4) über eine isolierende Schicht (5) angebracht sind, und wobei zumindest der Teil der dem Gehäuse (1) zugewandten Fläche der Grundplatte (2) mit den angebrachten elektrischen Leistungshalbleiterbauelementen (4) mit dem Gehäuse () vergossen ist, **dadurch gekennzeichnet, dass** der aushärtbare Vergusskunststoff ein thermoplastischer Schmelzklebstoff ist.

2. Leistungshalbleitermodul nach Anspruch 1, **dadurch gekennzeichnet, dass** die elektrische Leistungshalbleiterbauelemente (4) anstelle über die isolierende Schicht (5) im wesentlichen direkt auf der dem Gehäuse (1) zugewandten Fläche der Grundplatte (2) angebracht sind.

3. Leistungshalbleitermodul nach Anspruch 1 oder 2, **dadurch gekennzeichnet, dass** der Schmelzklebstoff ein Dimerfettsäurepolyamid enthält.

4. Leistungshalbleitermodul nach einem der vorhergehenden Ansprüche, **dadurch gekennzeichnet, dass** der Schmelzklebstoff im ausgehärteten Zustand im wesentlichen transparent ist.

5. Leistungshalbleitermodul nach einem der vorhergehenden Ansprüche, **dadurch gekennzeichnet, dass** der Schmelzklebstoff eine Vergiesstemperatur im Bereich zwischen 150°C und 220°C aufweist.

6. Leistungshalbleitermodul nach einem der vorhergehenden Ansprüche, **dadurch gekennzeichnet, dass** der Schmelzklebstoff mit einem Vergiessdruck im Bereich von 0,1MPa bis 0,5MPA vergiessbar ist.

7. Leistungshalbleitermodul nach Anspruch 1, **dadurch gekennzeichnet, dass** eine mit mindestens einem der elektrischen Leistungshalbleiterbauelemente (4) verbundene Ansteuereinrichtung (6) zumindest teilweise mit dem Gehäuse (1) vergossen ist.

8. Leistungshalbleitermodul nach Anspruch 7, **dadurch gekennzeichnet, dass** die Ansteuereinrichtung (6) eine Leiterplatte (7) mit einer den elektrischen Leistungshalbleiterbauelementen (4) zugewandten ersten Leiterplattenfläche (8) und mit einer den elektrischen Leistungshalbleiterbauelementen (4) abgewandten zweiten Leiterplattenfläche (9) aufweist,
dass die erste Leiterplattenfläche (8) mit dem Gehäuse (1) vergossen ist, und
dass die zweite Leiterplattenfläche (9) ausserhalb des Gehäuses (1) liegt.

9. Leistungshalbleitermodul nach Anspruch 8, **dadurch gekennzeichnet, dass** die zweite Leiterplattenfläche (9) mit einem Kühleelement (10) thermisch kontaktiert ist.

10. Leistungshalbleitermodul nach Anspruch 7, **dadurch gekennzeichnet, dass** mit der Ansteuereinrichtung (6) verbundene Ansteueranschlusselemente (11) mit dem Gehäuse (1) vergossen sind und Anschlussenden der Ansteueranschlusselemente (11) aus dem Gehäuse (1) geführt sind.

11. Leistungshalbleitermodul nach Anspruch 10, **dadurch gekennzeichnet, dass** die Ansteueranschlusselemente (11) als Kabel ausgebildet sind.

12. Leistungshalbleitermodul nach Anspruch 1, **dadurch gekennzeichnet, dass** mindestens ein mit mindestens einem der elektrischen Leistungshalbleiterbauelemente (4) verbundenes Leistungsanschlusselement (3) mit dem Gehäuse (1) vergossen ist, wobei ein Anschlussende des mindestens einen Leistungsanschlusselementes (3) aus dem Gehäuse (1) geführt ist, und
dass das mindestens eine Leistungsanschlusselement (3) als Kabel ausgebildet ist.
